# EUROPEAN PATENT APPLICATION

(11) **EP 1 717 337 A2**
(43) Date of publication of application: **02.11.2006**
(21) Application number: 05255240.3
(22) Date of filing: 25.08.2005
(51) Int. Cl.: C23C 14/34, G11B 5/00

(54) **Enhanced multi-component oxide-containing sputter target alloy compositions**

(30) Priority: 19.04.2005 US 110105
(71) Applicant: Heraeus, Inc., Chandler, AZ 85226 (US)
(72) Inventor: Racine, Michael Gene, Phoenix, AZ 85044 (US); Kennedy, Steven Roger, Chandler, AZ 85226 (US); Das, Anirban, Tempe, AZ 85283 (US); Cheng, Yuanda R, Phoenix, AZ 85048 (US)
(74) Representative: Hill, Justin John

(57) **Abstract**

A magnetic recording medium, including a substrate, and a data-storing thin film layer formed over the substrate. The data-storing thin film layer is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg. The multi-component oxide has a dielectric constant greater than 5.0. The sputter target is further comprised of chromium (Cr) and/or boron (B).

## Description

### FIELD OF THE INVENTION

The present invention relates to sputter targets and, more particularly, relates to magnetic data-storing thin films sputtered from sputter targets which are comprised of multi-component oxide-containing alloy compositions with improved metallurgical characteristics.

### DESCRIPTION OF THE RELATED ART

The process of DC magnetron sputtering is widely used in a variety of fields to provide thin film material deposition of a precisely controlled thickness and within narrow atomic fraction tolerances on a substrate, for example to coat semiconductors and/or to form films on surfaces of magnetic recording media. In one common configuration, a racetrack-shaped magnetic field is applied to the sputter target by placing magnets on the backside surface of the target. Electrons are trapped near the sputtering target, improving argon ion production and increasing the sputtering rate. Ions within this plasma collide with a surface of the sputter target causing the sputter target to emit atoms from the sputter target surface. The voltage difference between the cathodic sputter target and an anodic substrate that is to be coated causes the emitted atoms to form the desired film on the surface of the substrate.

In the reactive sputtering process, the vacuum chamber partially filled with a chemically reactive gas atmosphere, and material which is sputtered off of the target chemically reacts with the reactive species in the gas mixture to form a chemical compound which forms the film.

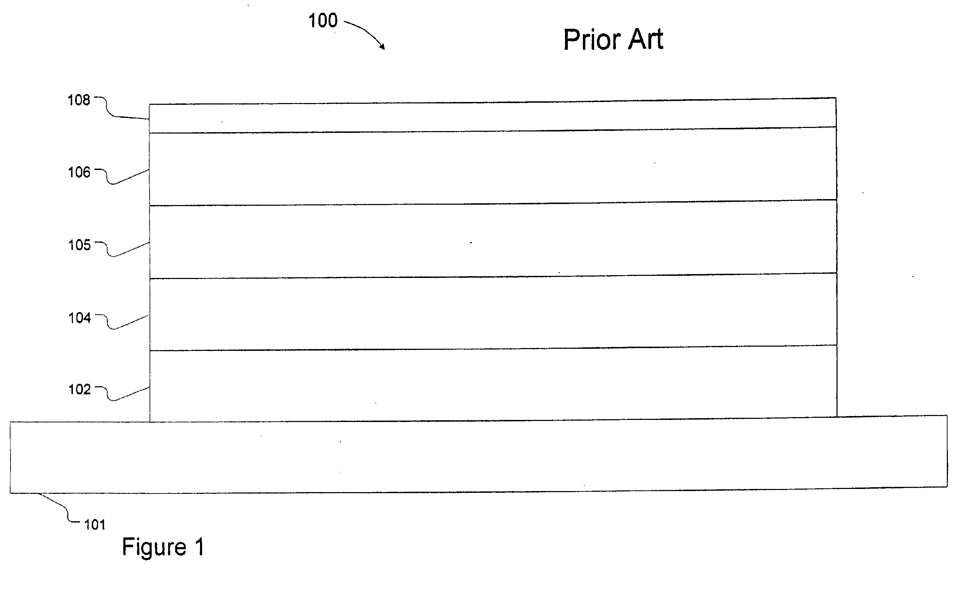

During the production of conventional magnetic recording media, layers of thin films are sequentially sputtered onto a substrate by multiple sputter targets, where each sputter target is comprised of a different material, resulting in the deposition of a thin film "stack." Figure 1 illustrates a typical thin film stack for conventional magnetic recording media. At the base of the stack is non-magnetic substrate 101, which is typically aluminum or glass. Seed layer 102, the first deposited layer, forces the shape and orientation of the grain structure of higher layers, and is commonly comprised of NiP or NiAl. Next, non-magnetic underlayer 104, which often includes one to three discrete layers, is deposited, where the underlayer is typically a chromium-based alloy, such as CrMo, or CrTi. Interlayer 105, which includes one or two separate layers, is formed above underlayer 104, where interlayer 105 is cobalt-based and lightly magnetic. Magnetic data-storing layer 106, which may include two or three separate layers, is deposited on top of interlayer 105, and carbon lubricant layer 108 is formed over magnetic layer 106.

The amount of data that can be stored per unit area on a magnetic recording medium is directly related to the metallurgical characteristics and the composition of the data-storing layer and, correspondingly, to the sputter target material from which the data-storing layer is sputtered. To sustain this continuous growth in data storage capacity, a technique known as "perpendicular magnetic recording" ("PMR"), as opposed to the conventional, "longitudinal magnetic recording" ("LMR"), has been the most promising and efficient technology for the magnetic data storage industry. Using PMR, bits are recorded perpendicular to the plane of the magnetic recording medium, allowing for a smaller bit size and greater coercivity. In return, PMR is expected to increase disk coercivity and strengthen disk signal amplitude, translating into superior archival data retention.

The key to achieving low media noise performance and high thermal stability is to provide a well-isolated fine grain structure coupled with large perpendicular magnetic anisotropy, or *K*_{*u*}. Oxygen containing CoCrPt or CoPt-based media not only provide a better grain-to-grain separation via an oxygen rich grain boundary phase, but they also suppress degradation of *K*_{*u*} without interfering with the epitaxial growth of the media. Oxides having little solid solubility in metals often get precipitated into grain boundary regions. Microstructural, magnetic and electrical separation of grains are key parameters in realizing discrete magnetic domains with little cross-talk and a high signal-to-noise ratio ("SNR").

The conventional approach to achieving these desired properties is to use single component oxide, such as SiO₂, Y2O₃, Al₂O₃, TiO₂, Ta₂O₅, Nb₂O₅, for media applications. This approach has provided significant improvement in the realization of well-isolated grain structures, and large *K*_{*u*} values in oxygen-containing magnetic media in forms of elements such as CoPtCrO, CoPtCr-SiO₂, CoPtTa₂O₅. These oxides, however, do not realize the best granular media performance with regard to SNR and thermal stability, within PMR media.

It is therefore considered highly desirable to provide a magnetic recording medium with a dense grain structure at the magnetic data-storing layer, to improve the signal-to-noise ratio and increase potential data storage capabilities. In particular, it is desirable to provide multi-component oxide-containing alloys which can be used in sputter targets and sputtered into thin films.

### SUMMARY OF THE INVENTION

The present invention relates to sputter targets and, more particularly, relates to magnetic data-storing thin films sputtered from sputter targets which are comprised of multi-component oxide-containing alloy compositions with improved metallurgical characteristics.

According to one arrangement, the present invention is a sputter target, where the sputter target is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

The use of a multi-component oxide-containing alloy composition enhances the grain-to-grain microstructural magnetic and electrical isolation, through the modulation of oxide properties of the different constituting oxides in the magnetic media. Specific metal oxides are used for this purpose which, when used in conjunction with known oxides such as SiO₂/Al₂O₃ and others, form a multi-component insulating oxide matrix encapsulating the magnetic grains.

The multi-component oxide has a dielectric constant greater than 5.0. The sputter target is further comprised of chromium (Cr) and/or boron (B).

In a first aspect, the multi-component oxide is further comprised of X₁, X₂, and oxygen (O), where X₁ and X₂ are elements selected from the group consisting of tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni). The multi-component oxide is further comprised of X₃, where X₃ is an element selected from the group consisting of aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

In a second, alternate aspect, the multi-component oxide is further comprised of X₁, X₂, and oxygen (O), where X₁ and X₂ are elements selected from the group consisting of silicon (Si), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni). The multi-component oxide is further comprised of X₃, where X₃ is an element selected from the group consisting of aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

In a third, alternate aspect, the multi-component oxide is further comprised of X₁, X₂, and oxygen (O), where X₁ and X₂ are elements selected from the group consisting of silicon (Si), tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

In a second arrangement, the present invention is a magnetic recording medium, including a substrate, and a data-storing thin film layer formed over the substrate. The data-storing thin film layer is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

According to a third arrangement, the present invention is a method for manufacturing a magnetic recording medium, including the step of sputtering at least a first data-storing thin film layer over a substrate from a sputter target. The sputter target is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

According to a fourth arrangement, the present invention is a sputter target, where the sputter target is comprised of cobalt (Co), platinum (Pt), at least one oxide, and at least one metal. When the sputter target is sputtered, the at least one oxide and the at least one metal render a multi-component oxide, where the multi-component oxide has cations with a reduction potential of less than -0.03 electron volts, and atomic radii of less than 0.25 nanometers. The multi-component oxide is diamagnetic, paramagnetic, or magnetic with a permeability of less than 10⁻⁶ m³/kg, and the multi-component oxide has a dielectric constant greater than 5.0.

According to a fifth arrangement, the present invention is a sputter target, where the sputter target is comprised of cobalt (Co), platinum (Pt), and at least first and second oxides. When the sputter target is sputtered, the first and second oxides render a multi-component oxide, where the multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg, and the multi-component oxide has a dielectric constant greater than 5.0.

According to a sixth arrangement, the present invention is a sputter target, where the sputter target is comprised of cobalt (Co), platinum (Pt), and at least first and second metals. When the sputter target is reactively sputtered, the first and second metals render a multi-component oxide, where the multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg, and the multi-component oxide has a dielectric constant greater than 5.0.

According to a seventh aspect, the present invention is a method for manufacturing a magnetic recording medium, including the step of sputtering at least a first data-storing thin film layer over a substrate from a sputter target. The sputter target is comprised of cobalt (Co), platinum (Pt), at least one oxide, and at least one metal, where the at least one oxide and the at least one metal render a multi-component oxide, where the multi-component oxide has cations with a reduction potential of less than -0.03 electron volts, and atomic radii of less than 0.25 nanometers, and where the multi-component oxide is diamagnetic, paramagnetic, or magnetic with a permeability of less than 10⁻⁶ m³/kg.

According to an eighth aspect, the present invention is a method for manufacturing a magnetic recording medium, including the step of sputtering at least a first data-storing thin film layer over a substrate from a sputter target. The sputter target is comprised of cobalt (Co), platinum (Pt), and at least a first and a second oxide, where the at least a first and second oxide render a multi-component oxide. The multi-component oxide has cations with a reduction potential of less than -0.03 electron volts, and atomic radii of less than 0.25 nanometers, and the multi-component oxide is diamagnetic, paramagnetic, or magnetic with a permeability of less than 10⁻⁶ m³/kg.

According to a ninth aspect, the present invention is a method for manufacturing a magnetic recording medium, including the step of reactively sputtering at least a first data-storing thin film layer over a substrate from a sputter target in the presence of oxygen (O). The sputter target is comprised of cobalt (Co), platinum (Pt), and at least a first and a second metal, where said at least a first and second metals render a multi-component oxide. The multi-component oxide has cations with a reduction potential of less than -0.03 electron volts, and atomic radii of less than 0.25 nanometers, and the multi-component oxide is diamagnetic, paramagnetic, or magnetic with a permeability of less than 10⁻⁶ m³/kg.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings in which like reference numbers represent corresponding parts throughout:

Figure 1 depicts a typical thin film stack for conventional magnetic recording media;

Figure 2 depicts a thin film stack in which the magnetic data-storing layer has been sputtered by a sputter target comprised of the enhanced multi-component oxide-containing sputter target alloy composition according to one embodiment of the present invention; and

Figure 3 is a flow chart depicting a method for manufacturing a magnetic recording medium, according to a second embodiment of the present invention.

### DETAILED DESCRIPTION OF THE INVENTION

The present invention provides a magnetic recording medium with a dense grain structure at the magnetic data-storing layer, which improves the signal-to-noise ratio and increases potential data storage capabilities. Furthermore, the present invention provides multi-component oxide-containing alloys which can be used in sputter targets and sputtered into thin films.

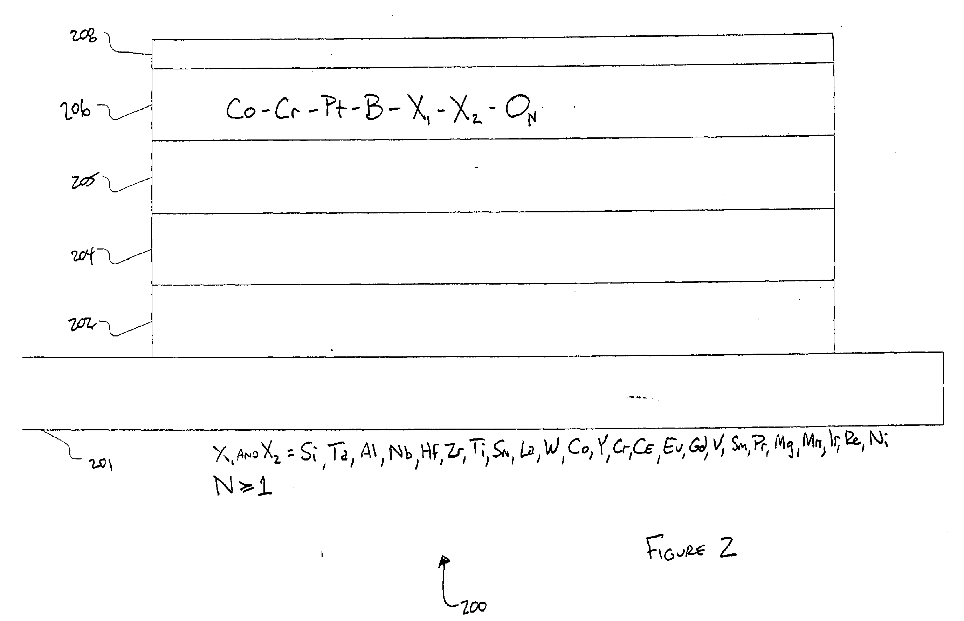

Figure 2 depicts a thin film stack in which the magnetic data-storing layer has been sputtered by a sputter target comprised of the enhanced multi-component oxide-containing sputter target alloy composition according to one embodiment of the present invention. Briefly, the magnetic recording medium includes a substrate, and a data-storing thin film layer formed over the substrate. The data-storing thin film layer is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

In more detail, magnetic recording medium 200 includes substrate 201, and data-storing thin film layer 206 formed over substrate 201. Data-storing thin film layer 206 is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

As indicated above, magnetic recording media 200 can include other thin film layers, including seed layer 202, non-magnetic underlayer 204, interlayer 205, and carbon lubricant layer 208, although in alternate embodiments of the present invention some or all of these layers are omitted.

The use of a multi-component oxide-containing alloy composition enhances the grain-to-grain microstructural magnetic and electrical isolation, through the modulation of oxide properties of the different constituting oxides in the magnetic media. Specific metal oxides can be used for this purpose which can be used in conjunction with known oxides, such as SiO₂/Al₂O₃ and others, to form an multi-component insulating oxide matrix encapsulating the magnetic grains.

The multi-component oxide has a dielectric constant greater than 5.0. The sputter target is further comprised of chromium (Cr) and/or boron (B). The addition of elements such as boron has long been used to enhance the grain-to-grain separation in LMR media. In an alternate aspect, the dielectric constant is greater than or less than 5.0, and/or chromium and/or boron are omitted.

Data-storing thin film layer 206 is particularly well suited for PMR applications. The choice of elements used in the metal oxide is based upon several criteria, where the use of different oxides with compensating and reinforcing properties re alizes the best granular media performance with regard to SNR and thermal stability in the perpendicular magnetic media.

In more detail, in order for PMR to achieve high recording density, the data-storing thin film layer must be comprised of a material with high thermal stability and low media noise performance. Granular magnetic media containing CoCrPt or CoPt-based alloys, with magnetic domains encapsulated in an insulating matrix, are not only highly resistive to thermal agitation due to their large magnetocrystalline anisotropy, but they also provide an enhanced performance regarding SNR, due to the gain size reduction. As grain refinement in the granular magnetic media approaches the limits of magnetic dipole stability, however, it becomes increasingly important to develop materials with sufficient grain-to-grain separation such that each grain is not magnetically influenced by its contiguous neighbors in the bulk.

For PMR, where the requirements for grain refinement and separation are much more stringent than LMR, an oxygen-containing grain boundary in granular media has been observed to render better magnetic properties, making the incorporation of oxygen through reactive sputtering and/or single oxide (such SiO₂ Al₂O₃, Ta₂O₅, or Nb₂O₅)-containing targets beneficial. The present invention further enhances the benefits of oxygen-rich grain boundary regions in magnetic media through the use of sputter targets containing multiple-component oxides. This objective is achieved through the modulation of different oxide properties related to oxidation propensity, glass formation tendency, and magnetic-dielectric behaviors in a multi-component oxide matrix incorporated in the magnetic media, using sputter targets containing multi-component oxides selected on the basis of specific criteria

Oxides which rarely form a solid solution with metals have the inherent tendency to precipitate in the grain boundary regions in CoCrPt or CoPt-based granular media and thereby enhance microstructural segregation of the magnetic grains. These oxides do not interfere with the epitaxial growth of the oxygen containing CoCrPt or CoPt-based thin film media and therefore lead to the suppression of degradation in Kᵤ.

Oxygen introduced through reactive sputtering in thin film magnetic media to enrich oxygen content in the grain boundaries, and use of single oxides in conjunction with CoCrPt and CoPt deliver better magnetic behavior in PMR media, due to the above-identified effects of the oxygen containing media. Oxygen-containing granular magnetic media manufactured using oxide-containing targets, however, have demonstrated superior magnetic performance than media containing oxygen incorporated through reactive sputtering.

Metal oxides are selected for use in sputter targets for granular magnetic media on the basis of the propensity towards oxidation and diffusive nature of the metal cations, and the oxide glass formation tendency and their magnetic, dielectric properties. In particular, the oxides have cations with oxidation potentials higher than that of cobalt (Co), which is the main magnetic component of the alloy, and thus the reduction potential should be less than -0.03 eV. As such, the cations of the oxides have higher propensities towards oxidation than other metallic components in the alloy. Table 1, below, shows the reduction potential of different several cations.

**Table 1:**

| Metal atom | Atomic radius (nm) | Metal atom | Atomic radius (nm) |
|---|---|---|---|
| Si | 0.14 | Zr | 0.21 |
| Al | 0.16 | Hf | 0.21 |
| Mg | 0.17 | Cr | 0.18 |
| Na | 0.22 | Co | 0.16 |
| K | 0.27 | Ni | 0.16 |
| Nb | 0.2 | Y | 0.22 |
| Ta | 0.2 | Mn | 0.18 |
| Ti | 0.2 | Ca | 0.23 |
| Zn | 0.15 | Sn | 0.17 |

Additionally, the oxides have cations with atomic radii of sufficient size to allow facile diffusion to the grain boundaries in the magnetic alloy, and are less than 0.25 nm. Table 2 provides the atomic radii of several different metals:

**Table 2.**

| Elements | Standard reduction potential (eV) | Elements | Standard reduction potential(eV) |
|---|---|---|---|
| Si+4 | -0.86 | Cr+4 | -.74 |
| Mg+2 | -2.37 | Cr+3 | -.41 |
| Al+3 | -1.66 | Fe+2 | -.44 |
| Ta+5 | -0.81 | Fe+3 | -.04 |
| Nb+5 | -0.63 | Cd+2 | -.40 |
| Hf+4 | -1.70 | Co+2 | -0.2 |
| Zn+2 | -0.76 | Ni+2 | -0.25 |
| Zr+4 | -1.53 | Sn+4 | -0.14 |
| Ca+2 | -2.86 | La+3 | -2.37 |
| Cu+1 | 3.39 | W+6 | -0.03 |
| Ti+4 | -1.63 | Na+1 | -2.714 |
| Pb+2 | -0.13 | K+1 | -2.925 |

Moreover, the oxides have minimal magnetic interference with the magnetic domains in the magnetic media, and are thus diamagnetic with negative permeabilities, paramagnetic, or very weekly magnetic with slightly positive permeabilities of less than 10⁻⁶ m³/Kg in nature. Table 3 shows the magnetic behavior of different metal oxides:

**Table 3.**

| Oxide | Dielectric constant | Magnetic susceptibility (10-8 m3/kg) | Oxide | Dielectric constant | Magnetic susceptibility (10-8 m3/kg) |
|---|---|---|---|---|---|
| SiO₂ | 3.9 | -0.45 | Co₂O₃ | 9.59 | 34.3 |
| MgO | 3.2 | -0.25 | Y₂O₃ | 14 | 0.5 |
| Al₂O₃ | 10.5 | -0.36 | Cr₂O₃ | 9.2 | 25.5 |
| Ta₂O₅ | 18 | -0.07 | CoO | 12.9 | 74.5 |
| Nb₂O₅ | 50 | -0.10 | MnO₂ | 13.8 | 68.5 |
| HfO₂ | 25 | -0.110 | Fe₃O₄ | 20 | 18.5 |
| ZnO | 18.0 | -0.36 | Fe₂O₃ | 18 | 10.5 |
| ZrO₂ | 22 | -0.112 | NiO | 11.9 | 54 |
| CaO | 3 | -0.27 | CuO | 9.77 | 3.8 |
| Cu₂O | 8.58 | -0.213 | CeO₂ | 21.2 | 30 |
| TiO₂ | 60 | -0.06 | Eu₂O₃ | 10.2 | 30 |
| SnO₂ | 24 | -0.26 | Gd₂O₃ | 11,4 | 140 |
| La₂O₃ | 20.8 | -0.4 | V₂O₅ | 13.84 | 7.5 |
| WO₃ | 20.2 | -0.065 | Sm₂O₃ | 21.5 | 5.8 |

The oxide matrix is highly insulating to prevent electrical conduction between the magnetic grains. Electrical leakage paths through non-insulating or weakly insulating grain boundaries lead to electrical conduction which, upon interaction with the applied magnetic field during magnetron sputtering, adversely affect the magnetic performance of the media as well as sputter performance of the targets. Thus the relative permittivities of the oxides are sufficiently high to make the encapsulating oxide matrix adequately insulating. Table 3, above, provides the dielectric behavior of different metal oxides.

In order to have dielectric permittivity of the multi-component oxide matrix sufficiently higher than that of single component oxides, the oxides are used in certain proportions to obtain the highest overall permittivity.

The oxide matrix is amorphous, such that inter-diffusion of the different elemental species between the magnetic grains is not facilitated through energetically-favored grain boundary diffusion in an otherwise crystalline matrix. This characteristic leads to better grain-to-grain microstructural and chemical encapsulation, by preventing intermediate reaction compounds formation and intermetallic formation as a byproduct of the inter-diffusion and interfacial reactions. Glass forming oxides, such as SiO₂, GeO₂, P₂O₅, or similar oxides, while used in combination with intermediates or conditional glass formers, such as Al₂O₃, ZrO₂, HfO₂, Ta₂O₅ or the like, form amorphous multi-component oxide phases with high crystallization temperature. An oxide or combination of oxides which are more amenable to glass formation are included in the magnetic media.

Use of multi-component oxide targets containing optimized proportions of different oxides selected on the basis of the proposed criteria realizes the respective merits of different oxides in the multi-component oxide matrix. The benefits of using multi-component oxides are realized in a variety of applications, including enhancement of dielectric constant, mechanical properties, and stability of amorphous or crystalline phases using two or more different oxides. Accordingly, use of sputter targets containing multi-component oxides to deposit thin film magnetic media provides a significant improvement of the magnetic behavior of the granular magnetic media for PMR.

The multi-component oxide is further comprised of X₁, X₂, and oxygen (O), where X₁ and X₂ are elements selected from the group consisting of silicon (Si), tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni). The multi-component oxide is further comprised of X₃, where X₃ is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni). In other aspects, element X₃ is omitted.

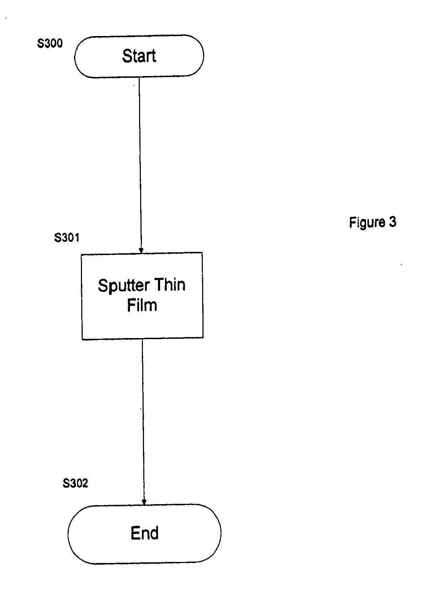

Figure 3 is a flow chart depicting a method for manufacturing a magnetic recording medium, according to a second embodiment of the present invention. The process begins (step S300), at least a first data-storing thin film layer is sputtered over a substrate from a sputter target (step S301), and the process ends (step S302).

According to a first aspect, the sputter target is comprised of cobalt (Co), platinum (Pt), and a multi-component oxide. According to a second, alternate aspect, the sputter target is comprised of cobalt (Co), platinum (Pt), at least one oxide, and at least one metal, where the at least one oxide and the at least one metal render the multi-component oxide. According to a third, alternate aspect, the sputter target is comprised of cobalt (Co), platinum (Pt), and at least a first and a second oxide, where the at least a first and second oxide render the multi-component oxide. According to a fourth, alternate aspect, the data-storing thin film layer is reactively sputtered, and the sputter target is comprised of cobalt (Co), platinum (Pt), and at least a first and a second metal, where said at least a first and second metals render the multi-component oxide.

The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

The present invention can be used to process magnetic films using sputter targets containing multi-component oxides, particularly in PMR applications, where the requirements grain structure refinement and isolation are more stringent in order to minimize degradation in SNR and realize a larger Kᵤ. Commercial horizontal recording media can also benefit from the essential attributes of a multi-component oxide matrix for grain refinement and isolation to enhance the magnetic performance.

According to a third arrangement, the present invention is a sputter target, where the sputter target is comprised of cobalt (Co), platinum (Pt), and a multi-component oxide. The multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg.

The multi-component oxide has a dielectric constant greater than 5.0. The sputter target is further comprised of chromium (Cr) and/or boron (B).

In a first aspect, the multi-component oxide is further comprised of X₁, X₂, and oxygen (O), where X₁ and X₂ are elements selected from the group consisting of tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni). The multi-component oxide is further comprised of X₃, where X₃ is an element selected from the group consisting of aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

In a second, alternate aspect, the multi-component oxide is further comprised of X₁, X₂, and oxygen (O), where X₁ and X₂ are elements selected from the group consisting of silicon (Si), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni). The multi-component oxide is further comprised of X₃, where X₃ is an element selected from the group consisting of aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

In a third, alternate aspect, the multi-component oxide is further comprised of X₁, X₂, and oxygen (O), where X₁ and X₂ are elements selected from the group consisting of silicon (Si), tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

According to a fourth arrangement, the present invention is a sputter target, where the sputter target is comprised of cobalt (Co), platinum (Pt), at least one oxide, and at least one metal. When the sputter target is sputtered, the at least one oxide and the at least one metal render a multi-component oxide, where the multi-component oxide has cations with a reduction potential of less than -0.03 electron volts, and atomic radii of less than 0.25 nanometers. The multi-component oxide is diamagnetic, paramagnetic, or magnetic with a permeability of less than 10⁻⁶ m³/kg, and the multi-component oxide has a dielectric constant greater than 5.0.

According to a fifth arrangement, the present invention is a sputter target, where the sputter target is comprised of cobalt (Co), platinum (Pt), and at least first and second oxides. When the sputter target is sputtered, the first and second oxides render a multi-component oxide, where the multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg, and the multi-component oxide has a dielectric constant greater than 5.0.

According to a sixth arrangement, the present invention is a sputter target, where the sputter target is comprised of cobalt (Co), platinum (Pt), and at least first and second metals. When the sputter target is reactively sputtered, the first and second metals render a multi-component oxide, where the multi-component oxide has cations with a reduction potential of less than -0.03 electron volts, and atomic radii of less than 0.25 nanometers. Additionally, the multi-component oxide is diamagnetic, paramagnetic, or magnetic with a permeability of less than 10⁻⁶ m³/kg, and the multi-component oxide has a dielectric constant greater than 5.0.

The invention has been described with particular illustrative embodiments. It is to be understood that the invention is not limited to the above-described embodiments and that various changes and modifications may be made by those of ordinary skill in the art without departing from the spirit and scope of the invention.

## Claims

1. A sputter target, wherein said sputter target is comprised of cobalt (Co), platinum (Pt), and a multi-component oxide,
wherein the multi-component oxide has cations with a reduction potential of less than -0.03 electron volts, and atomic radii of less than 0.25 nanometers, and
wherein the multi-component oxide is diamagnetic, paramagnetic, or magnetic with a permeability of less than 10⁻⁶ m³/kg.

2. The sputter target according to Claim 1, where the multi-component oxide has a dielectric constant greater than 5.0.

3. The sputter target according to Claim 1, wherein said sputter target is further comprised of chromium (Cr).

4. The sputter target according to Claim 1, wherein said sputter target is further comprised of boron (B).

5. The sputter target according to Claim 1, wherein said multi-component oxide is further comprised of X₁, X₂, and oxygen (O), wherein X₁ and X₂ are elements selected from the group consisting of tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

6. The sputter target according to Claim 1, wherein said multi-component oxide is further comprised of X₁, X₂, and oxygen (O), wherein X₁ and X₂ are elements selected from the group consisting of silicon (Si), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

7. The sputter target according to Claim 5, wherein said multi-component oxide is further comprised of X₃, wherein X₃ is an element selected from the group consisting of aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

8. The sputter target according to Claim 6, wherein said multi-component oxide is further comprised of X₃, wherein X₃ is an element selected from the group consisting of aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

9. The sputter target according to Claim 1, wherein said multi-component oxide is further comprised of X₁, X₂, and oxygen (O), wherein X₁ and X₂ are elements selected from the group consisting of silicon (Si), tantalum (Ta), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

10. A magnetic recording medium comprising:
a substrate; and
a data-storing thin film layer formed over said substrate,
wherein said data-storing thin film layer is comprised of cobalt (Co), platinum (Pt), and a multi-component oxide,
wherein the multi-component oxide has cations with a reduction potential of less than -0.03 electron volts, and atomic radii of less than 0.25 nanometers, and
wherein the multi-component oxide is diamagnetic, paramagnetic, or magnetic with a permeability of less than 10⁻⁶ m³/kg.

11. The magnetic recording medium according to Claim 10, wherein said data-storing thin film layer is further comprised of chromium (Cr).

12. The magnetic recording medium according to Claim 10, wherein said data-storing thin film layer is further comprised of boron (B).

13. The magnetic recording medium according to Claim 10, wherein said multi-component oxide is further comprised of X₁, X₂, and oxygen (O), wherein X₁ and X₂ are elements selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

14. The magnetic recording medium according to Claim 13, wherein said multi-component oxide is further comprised of X₃, wherein X₃ is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

15. A method for manufacturing a magnetic recording medium, comprising the step of sputtering at least a first data-storing thin film layer over a substrate from a sputter target, wherein the sputter target is comprised of cobalt (Co), platinum (Pt), and a multi-component oxide, wherein the multi-component oxide has cations with a reduction potential of less than -0.03 electron volts, and atomic radii of less than 0.25 nanometers, and wherein the multi-component oxide is diamagnetic, paramagnetic, or magnetic with a permeability of less than 10⁻⁶ m³/kg.

16. A sputter target, wherein said sputter target is comprised of cobalt (Co), platinum (Pt), at least one oxide, and at least one metal,
wherein, when the sputter target is sputtered, said at least one oxide and said at least one metal render a multi-component oxide, wherein the multi-component oxide has cations with a reduction potential of less than -0.03 electron volts, and atomic radii of less than 0.25 nanometers, wherein the multi-component oxide is diamagnetic, paramagnetic, or magnetic with a permeability of less than 10⁻⁶ m³/kg, and wherein the multi-component oxide has a dielectric constant greater than 5.0.

17. The sputter target according to Claim 16, wherein said sputter target is further comprised of chromium (Cr).

18. The sputter target according to Claim 16, wherein said sputter target is further comprised of boron (B).

19. The sputter target according to Claim 16, wherein said at least one oxide is further comprised of X₁ and oxygen (O), wherein X₁ is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

20. The sputter target according to Claim 16, wherein said at least one metal is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

21. The sputter target according to Claim 16, wherein said at least one oxide is further comprised of X₁ and oxygen (O),
wherein X₁ is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), Iridium (Ir), Rhenium (Re), and nickel (Ni); and
wherein said at least one metal is an element selected from the group consisting of silicon (Si), aluminum (Al), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

22. The sputter target according to Claim 16, wherein said at least one oxide is further comprised of X₁ and oxygen (O),
wherein X₁ is an element selected from the group consisting of aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), Iridium (Ir), Rhenium (Re), or nickel (Ni); and
wherein said at least one metal is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), or nickel (Ni).

23. A sputter target, wherein said sputter target is comprised of cobalt (Co), platinum (Pt), and at least first and second oxides,
wherein, when the sputter target is sputtered, said first and second oxides render a multi-component oxide, wherein the multi-component oxide has cations with a reduction potential of less than -0.03 electron volts, and atomic radii of less than 0.25 nanometers, wherein the multi-component oxide is diamagnetic, paramagnetic, or magnetic with a permeability of less than 10⁻⁶ m³/kg, and wherein the multi-component oxide has a dielectric constant greater than 5.0.

24. The sputter target according to Claim 23, wherein said sputter target is further comprised of chromium (Cr).

25. The sputter target according to Claim 23, wherein said sputter target is further comprised of boron (B).

26. The sputter target according to Claim 23, wherein said first oxide is further comprised of X₁ and oxygen (O), wherein X₁ is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

27. The sputter target according to Claim 23, wherein said second oxide is further comprised of X₂ and oxygen (O), wherein X₂ is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

28. A sputter target, wherein said sputter target is comprised of cobalt (Co), platinum (Pt), and at least first and second metals,
wherein, when the sputter target is reactively sputtered, said first and second metals render a multi-component oxide, wherein the multi-component oxide has cations with a reduction potential of less than -0.03 electron volts, and atomic radii of less than 0.25 nanometers, wherein the multi-component oxide is diamagnetic, paramagnetic, or magnetic with a permeability of less than 10⁻⁶ m³/kg, and wherein the multi-component oxide has a dielectric constant greater than 5.0.

29. The sputter target according to Claim 28, wherein said sputter target is further comprised of chromium (Cr).

30. The sputter target according to Claim 28, wherein said sputter target is further comprised of boron (B).

31. The sputter target according to Claim 28, wherein said first metal is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

32. The sputter target according to Claim 28, wherein said second metal is an element selected from the group consisting of silicon (Si), aluminum (Al), tantalum (Ta), niobium (Nb), hafnium (Hf), zirconium (Zr), titanium (Ti), tin (Sn), lanthanum (La), tungsten (W), cobalt (Co), yttrium (Y), chromium (Cr), cerium (Ce), europium (Eu), gadolinium (Gd), vanadium (V), samarium (Sm), praseodymium (Pr), magnesium (Mg), manganese (Mn), iridium (Ir), rhenium (Re), and nickel (Ni).

33. A method for manufacturing a magnetic recording medium, comprising the step of sputtering at least a first data-storing thin film layer over a substrate from a sputter target, wherein the sputter target is comprised of cobalt (Co), platinum (Pt), at least one oxide, and at least one metal, wherein said at least one oxide and said at least one metal render a multi-component oxide, wherein the multi-component oxide has cations with a reduction potential of less than -0.03 electron volts, and atomic radii of less than 0.25 nanometers, and wherein the multi-component oxide is diamagnetic, paramagnetic, or magnetic with a permeability of less than 10⁻⁶ m³/kg.

34. A method for manufacturing a magnetic recording medium, comprising the step of sputtering at least a first data-storing thin film layer over a substrate from a sputter target, wherein the sputter target is comprised of cobalt (Co), platinum (Pt), and at least a first and a second oxide, wherein said at least a first and second oxide render a multi-component oxide, wherein the multi-component oxide has cations with a reduction potential of less than -0.03 electron volts, and atomic radii of less than 0.25 nanometers, and wherein the multi-component oxide is diamagnetic, paramagnetic, or magnetic with a permeability of less than 10⁻⁶ m³/kg.

35. A method for manufacturing a magnetic recording medium, comprising the step of reactively sputtering at least a first data-storing thin film layer over a substrate from a sputter target in the presence of oxygen (O), wherein the sputter target is comprised of cobalt (Co), platinum (Pt), and at least a first and a second metal, wherein said at least a first and second metals render a multi-component oxide, wherein the multi-component oxide has cations with a reduction potential of less than -0.03 electron volts, and atomic radii of less than 0.25 nanometers, and wherein the multi-component oxide is diamagnetic, paramagnetic, or magnetic with a permeability of less than 10⁻⁶ m³/kg.
